Europäisches Patentamt

European Patent Office

Office européen des brevets

(11) Veröffentlichungsnummer: **0 188 477**
**B1**

(12) **EUROPÄISCHE PATENTSCHRIFT**

(45) Veröffentlichungstag der Patentschrift:
27.09.89

(21) Anmeldenummer: 85903268.2

(22) Anmeldetag: 01.07.85

(86) Internationale Anmeldenummer:
PCT/EP 85/00317

(87) Internationale Veröffentlichungsnummer:
WO 86/00418 (16.01.86 Gazette 86/2)

(51) Int. Cl.⁴: **G 01 R 31/36, H 02 J 7/10**

(54) **VERFAHREN UND EINRICHTUNG ZUR ÜBERWACHUNG DES LADEZUSTANDES VON WIEDERAUFLADBAREN BATTERIEN.**

(30) Priorität: 30.06.84 DE 3424191

(43) Veröffentlichungstag der Anmeldung:
30.07.86 Patentblatt 86/31

(45) Bekanntmachung des Hinweises auf die Patenterteilung:
27.09.89 Patentblatt 89/39

(84) Benannte Vertragsstaaten:
AT BE CH DE FR GB IT LI LU NL SE

(56) Entgegenhaltungen:
EP-A- 0 005 841
FR-A- 2 401 530
US-A- 439 084
US-A- 4 377 787

(73) Patentinhaber: KOPMANN, Udo, Kastanienstrasse 7,
D-6246 Glashütten/Ts. 1 (DE)

(72) Erfinder: KOPMANN, Udo, Kastanienstrasse 7,
D-6246 Glashütten/Ts. 1 (DE)

(74) Vertreter: Zenz, Joachim Klaus, Am Ruhrstein 1,
D-4300 Essen 1 (DE)

**Beschreibung**

Die Erfindung betrifft ein Verfahren zur Überwachung des Ladezustandes von wiederaufladbaren Batterien, insbesondere Nickel-Cadmium-Akkumulatoren, wobei ein einem bestimmten Ladezustand entsprechender Referenzwert gespeichert, die Klemmenspannung, die Stromstärke und die Zeit während jedes Lade- und Entladezyklus der Batterie gemessen und unter Berücksichtigung der Stromrichtung in eine der zugeführten bzw. verbrauchten Energiemenge entsprechende Größe umgesetzt werden, aus der, ausgehend von dem Referenzwert, die Ladezustands-Istwerte berechnet werden. Ferner bezieht sich die Erfindung auf eine Einrichtung zur Durchführung dieses Verfahrens. Unter dem nachfolgend verwendeten Begriff «wiederaufladbare Batterie» sind sowohl Einzelzellen als auch beliebig zusammengeschaltete Zellen zu verstehen.

Wiederaufladbare Batterien haben vor allem als Notstromaggregate für EDV-Anlagen, Maschinen- und Gerätesteuerungen, medizinische Geräte und als Stromversorgungsaggregate für Meßgeräte, Signal- und Warnanlagen sowie als Traktions- und Starterbatterien für Landfahrzeuge und in der Luft- und Raumfahrt zunehmend Bedeutung erlangt. In vielen Anwendungsfällen benötigt der Anwender zur Vermeidung eines Betriebsausfalls oder einer Betriebsunterbrechung der batterieversorgten Einrichtung, z.B. der EDV-Anlage oder einer Meß-, Steuer- oder Signalanlage, eine laufende und möglichst genaue Überwachung des Ladungszustandes der Batterien. Nur mit Hilfe einer Ladezustandskontrolle läßt sich die vorhandene Kapazität der Zellen voll ausnutzen und eine für die Batterie schädliche Überschreitung oder Unterschreitung bestimmter Ladungsgrenzen im Zuge der Ladung und Entladung vermeiden.

Bekannte Ladekontrolleinrichtungen für Nickel-Cadmium-Batterien arbeiten üblicherweise nach zwei verschiedenen Prinzipien:

Das einfachere Verfahren bestimmt den Ladezustand aufgrund der Klemmenspannung der Zellen. Dabei definiert eine Spannungsobergrenze den Zeitpunkt der Beendigung des Ladevorganges, eine Spannungsuntergrenze den Zeitpunkt der Beendigung der Entladung der Batterie. Der Indikator «Klemmenspannung» als Maß für die elektrochemischen Verhältnisse wird dadurch exakter, daß aus den gleichzeitig gemessenen Werten des Lade-/Entladestroms und der Zellentemperatur Korrekturfaktoren für die Klemmenspannung abgeleitet werden.

Von grundsätzlichem Nachteil ist, daß bei diesem Verfahren lediglich ein Signal für die Zustände «Volladung erreicht / Ladestrom abschalten / auf Erhaltungsladung umschalten» und «Batterie entladen / Verbraucher abschalten» gewonnen werden kann.

Das zweite bekannte Prinzip entspricht einem Coulometer. Dabei wird von einem definierten Zustand der Batterie (zumeist: Volladung) ausgehend, die entnommene Ladungsmenge gemessen. Ein Zähler oder eine Referenzkapazität wird mit Werten beaufschlagt, die proportional der zugeführten oder entnommenen Energiemenge sind, und aus der Differenz zwischen der Soll-Zellenkapazität und der entnommenen Ladungsmenge wird ein Signal für die verfügbare Restladung gebildet.

Wie schon beim vorgenannten Verfahren werden auch hier die Beiwerte Stromstärke und Zellentemperatur sowie der Ladefaktor zur Korrektur des angezeigten Wertes für die noch verfügbare Ladung berücksichtigt. In einigen Fällen wird sogar die Anzahl der bereits durchfahrenen Zyklen und die Standzeit der Batterie zu dem Zweck gemessen, den Einfluß der Alterung resp. der Selbstentladung der Zellen auf die Änderung der Soll-Kapazität der Batterie abzuschätzen.

Nachteilig bei diesem Verfahren ist, daß bei einem laufenden, zyklischen Betrieb der Batterien der aufgrund der Amperestundenmessung ermittelte Ladezustand vom tatsächlichen abweichen kann, weil trotz des Einbezugs verschiedener meßbarer Parameter das reale Batterieverhalten und damit die tatsächliche Kapazität der Zellen nicht hinreichend genau voraussehbar ist. Bei einem aus der DE-A-30 12 356 bekannten Coulometerverfahren wird deshalb versucht, diese Fehlerquelle durch ein handbetätigtes «Reset» nach jeder abgeschlossenen Volladung teilweise zu kompensieren, um den aufgrund der Messung von Energiezufuhr bzw. -abfuhr berechneten Ladezustand mit dem tatsächlichen Ladezustand zu vergleichen.

Aus der US-A-4 390 841 ist es bekannt, den Ladezustand einer wiederaufladbaren Batterie beim Laden und Entladen durch Messen der Spannung, des Stroms und der Temperatur der Zelle zu überwachen. Die Auswertung dieser Werte erfolgt in einem mathematischen Modell der Batterie, das in einem Mikroprozessor gespeichert ist.

Aus der Fr-A-2 401 530 ist es bekannt, die Änderungsgeschwindigkeit der Klemmenspannung als Abschaltkriterium beim Laden der Batterie zu verwenden. Eine Auswertung des Ladezustandes, d.h. die Erfassung der in der Batterie noch vorhandenen Restkapazität, ist bei dieser bekannten Anordnung nicht möglich.

Der Erfindung liegt die Aufgabe zugrunde, bei der coulometrischen Überwachung des Ladezustandes von wiederaufladbaren Batterien die Abweichungen der Meßwerte vom effektiven Ladezustand der überwachten Batterien zu minimieren und die ermittelten Ladezustands-Istwerte automatisch auch einem sich ändernden realen Batterieverhalten anzupassen.

Bei der Lösung dieser Aufgabe geht die Erfindung von der Erkenntnis aus, daß sowohl im Verlauf eines Ladezyklus als auch im Verlauf eines Entladezyklus konkrete Punkte auf den Lade- und Entlade-Klemmenspannungskennlinien identifizierbar sind, die Rückschlüsse sowohl auf den effektiven Ladezustand der Batterie bzw. Zelle als auch auf die noch verfügbare Ladungsmenge zulassen. Diese Punkte sind auf den Klemmenspannungskennlinien wie folgt definiert:

Beim Ladevorgang:

$A_1$ Beginn der Beschleunigung der Spannungszunahme (progressive Spannungsänderungsgeschwindigkeit) nach der Phase gleichmäßig geringer Spannungszunahmen pro Zeiteinheit (Plateauspannung);

$A_2$ Wendepunkt der Spannungszunahme;

$A_3$ Überschreiten einer definierten Spannungsobergrenze oder der Spitzenspannung.

Beim Entladevorgang:

$E_1$ Beginn der Beschleunigung der Spannungsabnahme (progressive Spannungsänderungsgeschwindigkeit) nach der Phase der gleichmäßig geringen Spannungsabnahme pro Zeiteinheit (Plateauspannung);

$E_2$ Unterschreiten einer definierten Spannungsobergrenze.

Unter Ausnutzung dieser Erkenntnis löst die Erfindung bei einem Verfahren der eingangs genannten Art die ihr zugrundeliegende Aufgabe dadurch, daß die Änderungsgeschwindigkeit der Klemmenspannung im Lade- und Entladezyklus überwacht wird, daß nach Durchlaufen einer Phase relativ gleichmäßiger und geringer Spannungsänderungsgeschwindigkeit wenigstens ein Zeitpunkt bestimmt wird, bei dem eine charakteristisch stärkere Spannungsänderungsgeschwindigkeit auftritt, und daß der berechnete Ladezustands-Istwert zu diesem oder einem definiert verzögerten Zeitpunkt auf den vorgegebenen Referenzwert abgeglichen wird.

Die Differenzen des elektrischen Energieinhalts zwischen diesen Punkten (im folgenden «Abgleichpunkte» genannt), stehen — jedenfalls unter der Voraussetzung kontinuierlicher Ladung und Entladung bei konstanten Strom- und Temperaturwerten — in einer bestimmten Beziehung zur Kapazität der Batterie(n) bei eingrenzbaren Toleranzen. Dabei ist zwar die Differenz des Energieinhalts zwischen den vollständige Ladung und Entladung kennzeichnenden Spannungsober- und -untergrenzen ein genaueres Maß für die Kapazität als diejenige zwischen den Punkten $A_1$ und $E_1$ oder $A_2$ und $E_1$; andererseits werden jedoch die Punkte $A_1$, $A_2$ und $E_1$ bei einem normalen zyklischen Betrieb, d.h. bei unvollständiger Ladung und Entladung, häufiger durchfahren als die Spannungsgrenzwerte, so daß ihre, erfindungsgemäß vorgesehene Verwendung als Abgleichpunkte zu einem häufigeren Abgleich und damit zu einer häufigeren Justierung des Meßvorgangs auf einen charakteristischen Referenzpunkt, verbunden mit einer größeren Genauigkeit der Ladezustandsbestimmung, führt. Durch diesen ständigen automatischen Abgleich wird auch der tatsächliche elektrochemische Zustand der überwachten Zelle(n) optimal erfaßt.

Die Einrichtung zur Überwachung des Ladezustandes von wiederaufladbaren Batterien zeichnet sich erfindungsgemäß aus durch Anordnungen zur Messung der Klemmenspannung der Batterie, der Richtung und Amplitude des Lade- bzw. Entladestroms und der Batterietemperatur, eine programmgesteuerte Recheneinheit, die mit den Meßanordnungen verbunden und so gesteuert ist, daß sie die Änderungesgeschwindigkeit der Klemmenspannung während aller Lade- und Entladezyklen der Batterie überwacht und einen Ladezustands-Istwert zu einem Zeitpunkt bestimmt, wenn die Spannungsänderungsgeschwindigkeit nach einer im wesentlichen konstanten Phase eine stärkere Änderung erfährt, einen Speicher, der zur Speicherung von Referenzwerten und der in der Recheneinheit entwickelten Istwerte der zugeführten bzw. verbrauchten Energiemengen mit der Recheneinheit verbunden ist, wobei der bestimmte Ladezustands-Istwert zu diesem oder einem zu diesem definiert verzögerten Zeitpunkt in der Recheneinheit auf den vorgegebenen Referenzwert abgeglichen wird, und eine Schnittstellen- und Treiberschaltung zur Kopplung der Recheneinheit mit peripheren Eingabe- und Ausgabegeräten.

Mit Hilfe der erfindungsgemäß vorgesehenen automatischen Korrektur des zum realen Lade/Entladezyklus parallel verlaufenden rechnerischen (coulometrischen) Lade/Entladezyklus kann die Erfindung auch zur Kontrolle und Zustandsanzeige verschiedener zyklischer elektrochemischer Prozesse eingesetzt werden, die entweder nicht exakt prognostizierbar ablaufen, oder deren Momentanzustand durch Messung von Referenzgrößen lediglich in seltenen Phasen eines Kreisprozesses erfaßbar ist.

Die Identifizierung der Abgleichpunkte dient nicht nur der Ermittlung der gesamten Ist-Kapazität der wenigstens einen Batterie. Zugleich entspricht den verschiedenen Abgleichpunkten jeweils ein bestimmter Ladezustand. Dieser bestimmte Ladezustand wird mit dem für diesen ermittelten Wert verglichen. Abweichungen beider Werte über eine für jeden Abgleichpunkt in der Regel gesondert festgelegte Bahndbreite hinaus führen automatisch zur Anpassung des Ladezustands-Istwerts an diesem Abgleichpunkt und zu einer entsprechenden Umskalierung der Restkapazitätsanzeige der coulometrischen Messung.

In der Weiterbildung des erfindungsgemäßen Verfahrens ist vorgesehen, daß die Ladezustands-Istwerte an den Abgleichpunkten eines Lade- und Entladezyklus bestimmt werden und die Differenz der Energieinhalte an den Abgleichpunkten als Maß für die Batteriekapazität verwendet wird. So beträgt beispielsweise die Differenz der Energieinhalte zwischen dem Abgleichpunkt $E_1$ (Beginn der progressiven Spannungsabnahmegeschwindigkeit beim Entladen) und dem Punkt $A_1$ etwa 70% der Batteriekapazität. Auf diese Weise läßt sich im Zuge eines Eichzyklus, bestehend aus einem Lade- und Entladevorgang mit Durchlauf von wenigstens zwei Abgleichpunkten, auch die Kapazität einer unbekannten Zellenanordnung aus der Differenz der Energieinhalte bestimmen bzw. durch Extrapolation erfassen.

Die Voraussetzungen für eine proportionale Zuordnung des Ladezustandes zu den Abgleichpunkten und des einfachen automatischen Abgleichs, nämlich konstante Ströme und Temperaturen während der Lade/Entladezyklen, sind in der Praxis selten erfüllt. Außerdem ist auch die Kontrolle des Ladezustandes unter variablen Lastverhältnissen und Zellentemperaturen von Bedeutung. Aus diesem Grunde sind auch bei der Erfindung zur Berücksichtigung der Betriebsvariablen laufende Temperatur- und Strommessungen, gegebenenfalls auch die Messung des Innenwiderstands der Batterie(n) vorgesehen, und diese Meßwerte werden als Korrekturgrößen bei der Berechnung der Ladezustands-Istwerte verwendet. Mit Hilfe eines gespeicherten Rechenprogramms kann in Abhängigkeit von diesen Korrekturwerten die laufende Messung der Spannungsverhältnisse bzw. die entnommene oder zugeführte Energiemenge normiert werden, wodurch auch die richtige automatische Identifizierung der Abgleichpunkte gewährleistet ist. Auf diese Weise wird ausgeschlossen, daß z.B. ein aufgrund von Stromstärkenänderungen oder Schaltvorgängen auftretender Spannungsabfall als Abgleichpunkt im Entladezyklus interpretiert wird.

Bei einer Mischentladung mit sprungartig wechselnden Entladeströmen kann die Fehlinterpretation eines Lastwechsels als Abgleichpunkt in Weiterbildung der Erfindung leicht dadurch vermieden werden, daß die Klemmenspannung überwacht wird und ein Abgleich des coulometrisch ermittelten Ladezustands-Ist-werts auf den dem jeweiligen Abgleichpunkt entsprechenden vorgegebenen Referenzwert nur dann erfolgt, wenn im Verlauf eines Entladezyklus eine vorgegebene Schwellenspannung unterschritten wird. Es wird also der Abgleichpunkt nur als solcher identifiziert, wenn die Entladung bereits zu einem bestimmten, relativ niedrigen Ladezustand fortgeschritten ist. Änderungen des Spannungsverhaltens der Batterie können aber auch in Abhängigkeit von Änderungen des gleichzeitig gemessenen Entladestroms rechnerisch kompensiert werden, so daß die mit Ladestromschwankungen einhergehende Verschiebung der Spannungskennlinie auf eine vorgegebene (normierte) Spannungs/Zeitkennlinie abgeglichen wird. Außerdem können Änderungen des Spannungsverhaltens der Batterie in Abhängigkeit von der Zellen- bzw. Batterietemperatur kompensiert werden, um Temperatureinflüsse auf die Ermittlung der Abgleichpunkte und des Ladezustandes im wesentlichen zu eliminieren. Die Temperaturkompensation kann außerdem in Abhängigkeit von zeitlichen Änderungen der Temperatur durch Bildung der Ableitung(en) vorgenommen werden; die Bestimmung der Spannungsänderungsgeschwindigkeit bedingt ohnehin die Bildung von Ableitungen, so daß das Programm des zugehörigen Rechners nicht zusätzlich kompliziert wird.

Die Meßwerte werden nach einer vorgegebenen, vorzugsweise variierbaren Taktfrequenz aufgenommen, verarbeitet und in regelmäßigen Zeitabständen gespeichert. Letzteres gilt insbesondere für Spannungswerte, die aus der coulometrischen Messung abgeleitet werden. Aus jeweils zwei aufeinanderfolgenden, gespeicherten Spannungswerten wird der Differenzquotient zur Zeit gebildet. Überschreitet dieser Differenzquotient einen Wert, der in Abhängigkeit von der Stromstärke und -richtung, der Temperatur und dem coulometrischen Ladezustand berechnet wird, so werden die Zeitintervalle für die Abspeicherung der Momentanspannung um einen Faktor verkürzt, der wiederum von der Stromstärke und Temperatur bestimmt wird. In diesen Phasen der höheren Taktfrequenz werden nicht nur die Momentanspannungen zwischengespeichert, sondern auch die jeweils ermittelten Differenzquotienten, und zwar aus den letzten zwei bis vier Meßtakten. Auf diese Weise können Ableitungen höherer Ordnung zur Ermittlung der negativen oder positiven Spannungsbeschleunigung approximiert werden. Ergibt die rechnerische Auswertung der «Feinmessung» bei relativ hoher Taktfrequenz, daß kein Abgleichpunkt erreicht ist, so kann der Meßtakt wieder auf die ursprüngliche Taktfrequenz reduziert werden.

Die coulometrische Ermittlung der zugeführten und entnommenen elektrischen Energiemenge kann durch eine Referenzkapazität (Memoriode) mit annähernd linearer Spannungs-Ladungs-Kurve unterstützt werden, die über der überwachten Batterie liegt und eine zeittaktunabhängige Integration von Strom und Zeit ermöglicht.

Im folgenden wird die Erfindung anhand der Zeichnung näher erläutert. Es zeigen:

Fig. 1 ein Blockschaltbild eines Ausführungsbeispiels der Einrichtung zur Überwachung des Batterie-Ladezustandes mit einer an die überwachte Batterie angeschalteten Last (Entladezyklus);

Fig. 2 eine Spannungs/Zeit-Kennlinie im Entladezyklus einer NiCd-Zelle im Entladezyklus;

Fig. 3 eine charakteristische Spannungs/Zeit-Kennlinie im Ladezyklus.

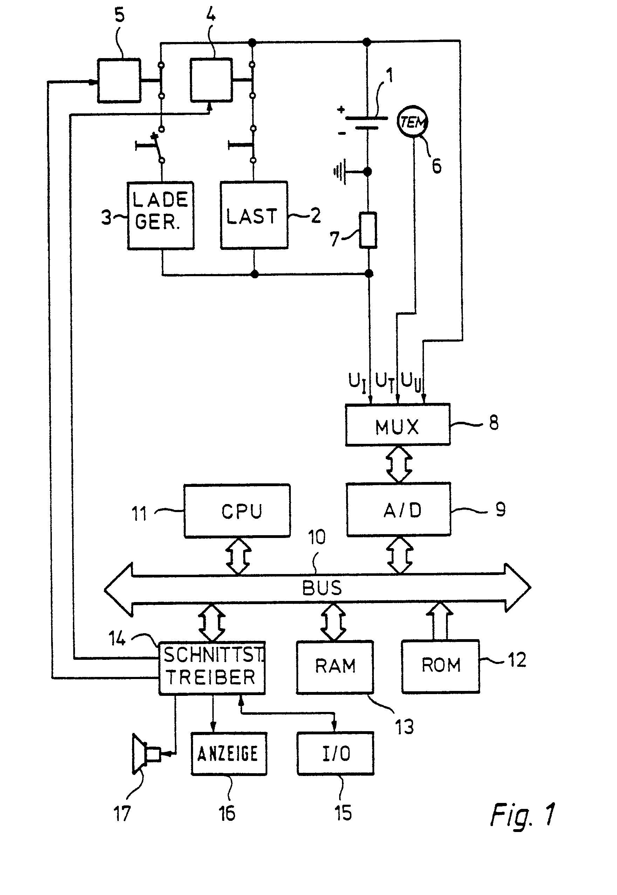

Die Anordnung gemäß Fig. 1 zeigt eine im beschriebenen Beispiel durch eine NiCd-Zelle gebildete Batterie 1, die im dargestellten Entladevorgang eine Last 2 mit Strom versorgt und über ein Ladegerät 3 aufgeladen werden kann. Handbetätigbare Schalter und automatisch über Stellglieder, z. B. Relais oder Schalttransistoren 4, 5 betätigbare Kontakte ermöglichen das Schließen und Öffnen der Lade- und Entladeschleifen zur Batterie 1.

Die Ladezustands-Überwachungseinrichtung erfaßt in dem beschriebenen Ausführungsbeispiel drei Meßgrößen, nämlich ein der Klemmenspannung der Batterie 1 proportionales Potential $U_U$, ein der Zellentemperatur proportionales Potential $U_T$ durch einen Temperaturdetektor 6 und ein dem im Endlade- oder Ladekreis über die Batterie 1 fließenden Strom nach Größe und Richtung proportionales Potential $U_I$. Letzteres wird über einen Präzisionswiderstand 7 zum Massenpunkt abgegriffen; der Massenpunkt ist mit dem negativen Pol der Batterie 1 verbunden. Die drei analogen Potentiale $U_I$, $U_T$ und $U_U$ werden gegebenenfalls verstärkt über einen Multiplexer 8, einen die analogen Meßwerte digitalisierenden Analog/Digital-Umsetzer 9 und einen Bus 10 einer programmgesteuerten CPU 11 zugeführt. Die CPU ist vorzugsweise Bestandteil eines Mikroprozessors; ihr Programm ist in einem gegebenenfalls programmierbaren Festwertspeicher (ROM) 12 gespeichert. Als Arbeitsspeicher dient ein Lese-Schreib-Speicher (RAM) 13. Beide Speicher 12 und 13 stehen über den Bus 10 mit der CPU 11 in Verbindung.

Eine Peripherieschnittstellen-Treiberschaltung 14 verbindet die CPU 11 mit allen Peripheriegeräten. Im dargestellten Ausführungsbeispiel gehören hierzu die Eingabe/Ausgabeeinheit (I/0) 15, eine optische Anzeigeeinrichtung, beispielsweise ein optischer Melder oder Monitor 16, eine akustische Meldeeinrichtung 17 sowie die Stellglieder 4 und 5 zur Unterbrechung der Last- und Ladestromkreise.

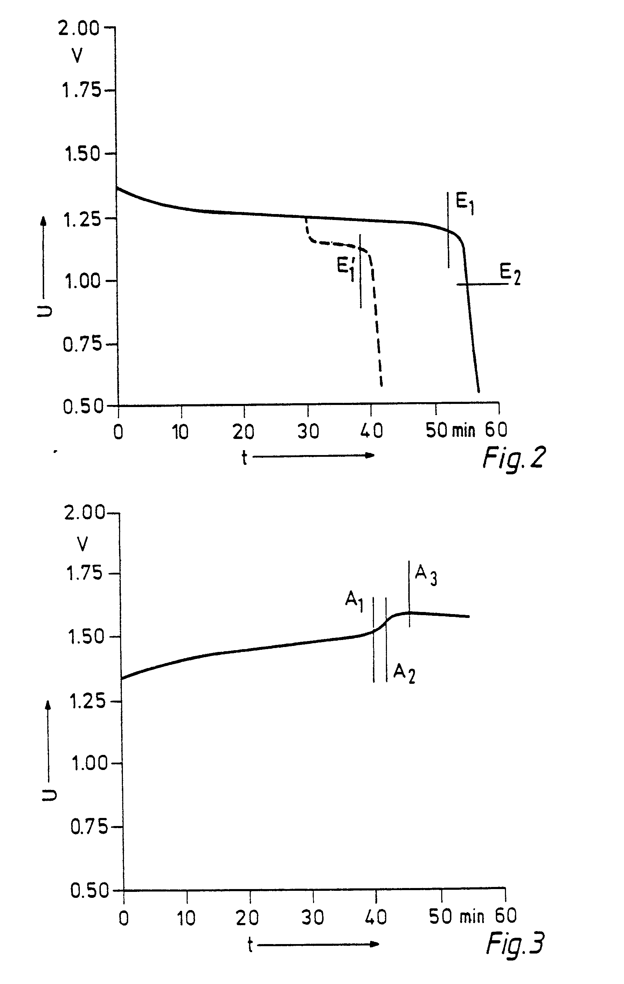

Im folgenden wird die Funktionsweise der Anordnung gemäß Figur 1 in Verbindung mit in den Figuren 2 und 3 dargestellten charakteristischen Verläufen der Klemmenspannungskennlinien bei den Entlade- und Ladezyklen beschrieben. Bei Beginn des Entladevorgangs ist die Nennkapazität der Batterie 1 je nach Anwendungsfall der beschriebenen Überwachungseinrichtung im Programmspeicher 12 und/oder im Arbeitsspeicher 13 gespeichert. Die der Batterie 1 entnommene Ladungsmenge wird coulo-

metrisch aus den Meßwerten $U_I$ und $U_U$ sowie aus der von einem prozessoreigenen Taktgeber abgeleiteten Zeit gewonnen, im Arbeitsspeicher 13 aktualisiert und in der CPU durch Vergleich mit der Soll- oder Nennladung in eine verfügbare Restladung umgesetzt, die beispielsweise auf der Anzeigeeinheit 16 zur Anzeige gebracht wird. Die Klemmenspannung $U_U$ bleibt gemäß Darstellung in Fig. 2 bis zu einer Entladung von etwa 80 bis 85%, also einer Restladung von etwa 20 bis 15% nahezu konstant (Plateauspannung). Danach erhöht sich die Änderungsgeschwindigkeit der Klemmenspannung $U_U$, und diese Erhöhung der Änderungsgeschwindigkeit identifiziert die CPU als Abgleichpunkt $E_1$. Diese Identifizierung wird von der CPU durch Bildung oder Approximation der Ableitung (Differentiation) der Spannung/Zeitkennlinie gewonnen und gegebenenfalls durch Ableitungen höherer Ordnungen und höhere Taktfrequenzen, verbunden mit höheren Digitalisierungsfrequenzen des A/D-Wandlers 9 präzisiert. Bei jedem Entladevorgang ist diesem Abgleichspunkt $E_1$ ein relativ genau vorbestimmbarer Wert für die noch verfügbare Restladung (vorgegebener Referenzwert) zugeordnet. Mit diesem vorgegebenen Referenzwert wird der laufend coulometrisch ermittelte Ladezustands-Istwert verglichen und bei unzulässig großen Unterschieden auf ihn abgeglichen. Außerdem gibt die Identifizierung des Abgleichpunktes $E_1$ ein zuverlässiges Indiz dafür, daß die auf der Kennlinie mit $E_2$ bezeichnete Spannungsuntergrenze im Entladezyklus (Fig. 2) noch nicht erreicht ist.

Wird danach die Last von der Batterie 1 abgetrennt und beispielsweise durch Handbetätigung des Schalters im Ladekreis das Ladegerät 3 an die Batterie 1 angeschaltet, so stellt die CPU 11 durch Vorzeichenumkehr des stromabhängigen Potentials $U_I$ den Beginn des Ladezyklus fest. Die Speicherung und coulometrische Messung der Ladeenergiemenge erfolgt mit Hilfe der CPU 11 und des Arbeitsspeichers 13 in prinzipiell der gleichen Weise wie beim Entladen. Die Klemmenspannung $U_U$ hat etwa den durch die Kennlinie gemäß Fig. 3 dargestellten Verlauf. Auch hier gibt es über eine relativ lange Zeitphase eine nahezu konstante Spannungsänderung bis zu dem in Fig. 3 durch $A_1$ kenntlich gemachten Punkt einer progressiven Spannungszunahme. Am Punkt $A_1$ ist die Zelle auf etwa 85–90% ihrer Kapazität aufgeladen. Identifiziert wird der Punkt $A_1$ ähnlich dem Punkt $E_1$ durch Bestimmung der Klemmenspannungsänderungsgeschwindigkeit, die sich an diesem Punkte gegenüber der Änderungsgeschwindigkeit im Bereich des vorausgegangenen Plateauspannungsabschnitts erkennbar ändert. In der vorausgegangenen Entladephase wurde die coulometrische Bestimmung der Lademenge am Punkt $E_1$ auf einen Referenzwert abgeglichen, der ein (genaueres) Maß für die tatsächlich verfügbare Restladung und damit den Ladezustand der Batterie darstellt. Die Restladung am Punkt $E_1$ und die während des vorausgegangenen Teilladezyklus bis zum Abgleichpunkt $A_1$ gemessene zugeführte Energie stellen den Ladezustands-Istwert der Batterie 1 dar und ermöglichen sogar eine Eichung der Überwachungseinrichtung an die jeweils überwachte Batterie 1. Nach diesen dem Rechner 11 verfügbaren Daten kann der coulometrische Ladezustands-Istwert nach dem Referenzwert für den Abgleichpunkt $A_1$ erneut abgeglichen und im Arbeitsspeicher 13 abgelegt werden. Weitere charakteristische Punkte sind bei Fortsetzung des Ladezyklus ein Wendepunkt $A_2$ in der Spannungs/Zeit-Kennlinie und das Überschreiten einer Maximal- oder Spitzenspannung etwa am Punkt $A_3$. Alle Punkte $A_1$, $A_2$ und $A_3$ lassen sich durch Ableitungen gegebenenfalls höherer Ordnung des in Fig. 3 dargestellten Verlaufs der Klemmenspannung $U_U$ identifizieren. Bei jedem Durchlauf durch einen der Punkte $E_1$ und $A_1$ bzw. $A_2$ findet ein neuer Abgleich des coulometrisch ermittelten Ladezustands-Istwerts statt, jedenfalls dann, wenn sich größere Differenzen zwischen dem vorgegebenen Referenzwert des Abgleichpunkts und dem coulometrisch ermittelten Ladezustands-Istwert ergeben. Die coulometrische Messung wird danach nach dem aktualisierten, also auf den Referenzwert am letzten Abgleichpunkt abgeglichenen Ladezustands-Istwert fortgesetzt.

Aufgrund der Identifizierung vorgegebener Punkte $E_1$ und $A_1$ bzw. $A_2$ läßt sich ein Unter- oder Überschreiten der Grenzspannungen durch Unterbrechen der Entlade- bzw. Ladekreise mit Hilfe der Überwachungseinrichtung zuverlässig vermeiden. Damit ist auch eine Gewähr für eine hohe Lebensdauer der überwachten Batterie oder Batteriegruppe gegeben.

Lastwechsel, von denen einer in Fig. 2 durch eine gestrichelte Spannungskennlinie dargestellt ist, lassen sich aufgrund der laufenden Strommessung als solche identifizieren; der generelle Verlauf der Klemmenspannung $U_U$ bleibt auch nach Lastwechsel erhalten, so daß auch mit der neuen Last ein zugehöriger Abgleichpunkt $E'_1$ am Ende einer Plateauspannung auftritt. Das Programm im ROM 12 kann auch eine Normierungskennlinie beinhalten, auf die die durch Last- und Temperatureinflüsse geänderte Spannungs/Zeitkennlinie in Abhängigkeit von den sich ändernden Strom- und Temperaturwerten bezogen und abgestimmt wird.

**Patentansprüche**

1. Verfahren zur Überwachung des Ladezustandes von wiederaufladbaren Batterien, insbesondere Nickel-Cadmium-Akkumulatoren, wobei ein einem bestimmten Ladezustand entsprechender Referenzwert gespeichert, die Klemmenspannung, die Stromstärke und die Zeit während jedes Lade- und Entladezyklus der Batterie gemessen und unter Berücksichtigung der Stromrichtung in eine der zugeführten bzw. verbrauchten Energiemenge entsprechende Größe umgesetzt werden, aus der, ausgehend von dem Referenzwert, die Ladezustands-Istwerte berechnet werden, dadurch gekennzeichnet, daß die Änderungsgeschwindigkeit der Klemmenspannung im Lade- und Entladezyklus überwacht wird, daß nach Durchlaufen einer Phase relativ gleichmäßiger und geringer Spannungsänderungsgeschwindigkeit wenigstens ein Zeitpunkt bestimmt wird, bei dem eine charakteristische stärkere Spannungsänderungsgeschwindigkeit auftritt, und daß der berechnete Ladezustands-Istwert zu diesem oder einem zu diesem definiert verzögerten Zeitpunkt auf den vorgegebenen Referenzwert abgeglichen wird.

2. Verfahren nach Anspruch 1, dadurch gekennzeichnet, daß die Ladezustands-Istwerte an den Abgleichpunkten eines Lade- und Entladezyklus bestimmt werden und die Differenz der Energieinhalte an den Abgleichpunkten als Maß für die Batteriekapazität verwendet wird.

3. Verfahren nach Anspruch 1 oder 2, dadurch gekennzeichnet, daß der bestimmte Zeitpunkt, bei dem eine charakteristische Spannungsänderungsgeschwindigkeit auftritt, der Beginn einer progressiven Spannungsänderung ist.

4. Verfahren nach einem der Ansprüche 1 bis 3, dadurch gekennzeichnet, daß der bestimmte Zeitpunkt, bei dem die charakteristische Spannungsänderungsgeschwindigkeit auftritt, ein Wendepunkt der Spannungszunahme im Verlaufe eines Ladevorgangs ist.

5. Verfahren nach einem der Ansprüche 1 bis 4, dadurch gekennzeichnet, daß die Klemmenspannung überwacht wird und ein Abgleich des coulometrisch ermittelten Ladezustands-Istwerts auf den dem jeweiligen Abgleichpunkt entsprechenden vorgegebenen Referenzwert nur dann erfolgt, wenn im Verlauf eines Lade-/Entladezyklus eine vorgegebene Schwellenspannung über- oder unterschritten wird.

6. Verfahren nach einem der Ansprüche 1 bis 5, dadurch gekennzeichnet, daß zusätzlich die Batterie- oder Zellentemperatur gemessen und bei der Identifizierung der Abgleichpunkte und der Berechnung der Ladezustands-Istwerte berücksichtigt wird.

7. Verfahren nach einem der Ansprüche 1 bis 6, dadurch gekennzeichnet, daß Änderungen des Spannungs/Zeitverhaltens der Batterie in Abhängigkeit von Änderungen des Lade- oder Entladestroms rechnerisch kompensiert werden.

8. Verfahren nach einem der Ansprüche 1 bis 7, dadurch gekennzeichnet, daß Änderungen des Spannungs/Zeitverhaltens der Batterie in Abhängigkeit von der Zellen- bzw. Batterietemperatur kompensiert werden.

9. Verfahren nach einem der Ansprüche 1 bis 8, dadurch gekennzeichnet, daß die Meßwerte nach einer vorgegebenen, variierbaren Taktfrequenz aufgenommen und verarbeitet werden und daß die Taktfrequenz im Bereich der Abgleichpunkte zur Erhöhung der Meßgenauigkeit erhöht wird.

10. Verfahren nach einem der Ansprüche 1 bis 9, dadurch gekennzeichnet, daß die Änderungsgeschwindigkeit der Klemmenspannung durch Berechnung von Differenzquotienten aus Spannung und Zeit ermittelt wird und daß unter Zuhilfenahme einer Zwischenspeicherung von Differenzquotienten Ableitungen höherer Ordnung zur Identifizierung der Abgleichpunkte gewonnen werden.

11. Einrichtung zur Durchführung des Verfahrens nach einem der Ansprüche 1 bis 10, gekennzeichnet durch

Anordnungen zur Messung der Klemmenspannung ($U_U$) der Batterie (1), der Richtung und Amplitude des Lade- bzw. Entladestroms und der Batterietemperatur ($U_T$).

eine programmgesteuerte Recheneinheit (11), die mit den Meßanordnungen verbunden und so gesteuert ist, daß sie die Änderungsgeschwindigkeit der Klemmenspannung ($U_U$) während aller Lade- und Entladezyklen der Batterie (1) überwacht und einen Ladezustands-Istwert zu einem Zeitpunkt bestimmt, wenn die Spannungsänderungsgeschwindigkeit nach einer im wesentlichen konstanten Phase eine stärkere Änderung erfährt,

einen Speicher (12, 13), der zur Speicherung von Referenzwerten und der in der Recheneinheit entwickelten Istwerte der zugeführten bzw. verbrauchten Energiemengen mit der Recheneinheit (11) verbunden ist, wobei der bestimmte Ladezustands-Istwert zu diesem oder einem zu diesem definiert verzögerten Zeitpunkt in der Recheneinheit auf den vorgegebenen Referenzwert abgeglichen wird, und

eine Schnittstellen- und Treiberschaltung (14) zur Kopplung der Recheneinheit (11) mit peripheren Eingabe- und Ausgabegeräten (15, 16, 17, 4, 5).

12. Einrichtung nach Anspruch 11, dadurch gekennzeichnet, daß die Meßanordnungen über einen Multiplexer (8), einen Analog/Digital-Umsetzer (9) und einen Bus (10) mit der Recheneinheit (11) verbunden sind.

13. Einrichtung nach Anspruch 12, dadurch gekennzeichnet, daß die Abtastfrequenz des Analog/Digital-Umsetzers (9) durch die Recheneinheit (11) steuerbar ist.

14. Einrichtung nach einem der Ansprüche 11 bis 13, dadurch gekennzeichnet, daß die Strommeßanordnung einen Präzisionswiderstand (7) aufweist, der im Stromkreis der Batterie (1) liegt und an seiner mit der Batterie verbundenen Seite auf einem vorgegebenen Potential gehalten ist.

15. Einrichtung nach einem der Ansprüche 11 bis 14, dadurch gekennzeichnet, daß ein Programmspeicher (12) zur Steuerung der Recheneinheit (11) vorgesehen ist, der ein Programm zur Korrektur der Ladungszustands-Istwerte und der Abgleichpunkte in Abhängigkeit von Temperatur- und Stromänderungen enthält.

16. Einrichtung nach einem der Ansprüche 11 bis 15, dadurch gekennzeichnet, daß die Schnittstellen- und Treiberschaltung (14) mit Stellgliedern bzw. Schaltern (4, 5) zum Unterbrechen der Lade- und Entladestromkreise bei Über- oder Unterschreiten vorgegebener Grenzwerte der Klemmenspannung ($U_U$) versehen ist.

**Claims**

1. A method of monitoring the state of charge of rechargeable batteries and, more particularly, nickel-cadmium storage batteries wherein a reference value corresponding to a certain state of charge is stored, the terminal voltage, the current and the time during each battery charging and discharging cycle are measured and the quantities so measured are converted into a quantity corresponding to the energy charged or discharged, and accounting for the direction of current flow, said quantity being used for computing the actual state of charge based on said reference value, characterized in that the rate of change in said terminal voltage is monitored during said charging and discharging cycles, in that at least one point of time, following a phase of relatively steady and low rate of change in said terminal voltage, is determined, at which point a characteristic higher rate of change in said terminal voltage occurs and in that the computed actual state of charge at said point or at another point delayed with respect to said point by a predetermined margin is adjusted to said predetermined reference value.

2. A method according to claim 1 characterized in that the actual states of charge are determined at the adjustment points in the charging and the discharging cycle and in that the difference between the energies stored at said two points is used as a measure of the capacity of a battery.

3. A method according to claim 1 or 2 characterized in that said point of time at which a characteristic rate of change in voltage occurs is the beginning of a progressive change in voltage.

4. A method according to any of claims 1 through 3 characterized in that said point of time at which said characteristic rate of change in voltage occurs is a point of inflection in the curve plotting the increase in voltage during a charging cycle.

5. A method according to any of claims 1 through 4 characterized in that said terminal voltage is monitored and in that the state of charge determined by coulometry at each adjustment point is only adjusted to said predetermined reference value for said adjustment point if a certain limit voltage is exceeded during a charging or a discharging cycle.

6. A method according to any of claims 1 through 5 characterized in that the battery temperature is also measured and in that the temperature so measured is accounted for in the identification of said adjustment points and in the computation of the states of charge.

7. A method according to any of claims 1 through 6 characterized in that changes in the voltage-versus-time behavior of any such battery are compensated for by computing means in response to changes in the charge or discharge current.

8. A method according to any of claims 1 through 7 characterized in that changes in the voltage-versus-time behavior of any such battery are compensated for in response to the battery temperature.

9. A method according to any of claims 1 through 8 characterized in that quantities are measured and processed at a predetermined scanning frequency which may be varied and in that said scanning frequency is increased close to said adjustment points to improve the accuracy of measurement.

10. A method according to any of claims 1 through 9 characterized in that the rate of change in terminal voltage is determined by computing voltage over time derivatives and in that, by way of the intermediate storage of derivatives, higher order derivatives are obtained for identifying said adjustment points.

11. An apparatus for carrying out the method according to any of claims 1 through 10 characterized by

means for measuring the terminal voltage ($U_U$) of the battery (1), the direction and the amplitude of the charging and discharging currents and the battery temperature ($U_T$),

a program-controlled central processing unit (11) connected with said measuring means and controlled to monitor the rate of change in the terminal voltage ($U_U$) during all charging and discharging cycles of said battery (1) and to determine an actual state of charge at a point of time at which, following a substantially constant phase, said rate of change undergoes a major shift,

memory means (12, 13) connected with said central processing unit (11) for storing reference values and the actual energy input and energy output values computed by said central processing unit said actual state of charge being adjusted by said central processing unit to said predetermined reference value at this point of time or at another point delayed for a defined time interval with respect to this point and

an interface and driving (14) for coupling said central processing unit (11) with peripheral input and output units (15, 16, 17, 4, 5).

13. An apparatus according to claim 12 characterized in that the scanning frequency of said analog-to-digital converter (9) may be controlled by said central processing unit (11).

14. An apparatus according to any of claims 11 to 13 characterized in that said means for measuring current comprises a high-precision resistor (7) included in the current circuit of the battery (1) and maintained at a predetermined potential at one end which is connected with said battery.

15. An apparatus according to any of claims 11 to 14 characterized in that a program storage means (12) for controlling said central processing unit (11) is provided, said program storage means containing a program for correcting the actual state of charge determined and the adjustment points in response to changes in temperature and current.

16. An apparatus according to any of claims 11 to 15 characterized in that said interface and driving circuit (14) is provided with actuating and switch means (4, 5) for interrupting the battery charge and discharge circuits if predetermined limits for the terminal voltage ($U_U$) are exceeded.

**Revendications**

1. Procédé de surveillance de l'état de charge de batteries rechargeables, en particulier d'accumulateurs nickel-cadmium, dans lequel on mémorise une valeur de référence, correspondant à un état de charge déterminé, on mesure la tension aux bornes, l'intensité de courant et le temps pendant chaque cycle de charge et décharge de la batterie et, en tenant compte du sens du courant, on les transforme en une grandeur correspondant à la quantité d'énergie fournie ou consommée, de laquelle, partant de la valeur de référence, on calcule la valeur effective de l'état de charge, caractérisé par le fait qu'on surveille la vitesse de variation de la tension aux bornes dans le cycle de charge et de décharge, qu'après parcours d'une phase de vitesse de variation de tension relativement uniforme et faible, on détermine un moment auquel apparaît une vitesse de variation de tension plus forte de façon caractéristique et on aligne sur la valeur de référence préfixée la valeur effective d'état de charge calculée à ce moment ou à un moment en retard défini par rapport à celui-ci.

2. Procédé selon la revendication 1, caractérisé par le fait qu'on détermine la valeur effective d'état de charge aux points d'alignement d'un cycle de charge et décharge et on utilise la différence des teneurs en energie aux points d'alignement comme mesure de la capacité de la batterie.

3. Procédé selon la revendication 1 ou 2, caractérisé par le fait que le moment déterminé auquel apparaît une vitesse de variation de tension caractéristique est le début d'une variation de tension progressive.

4. Procédé selon l'une des revendications 1 à 3, caractérisé par le fait que le moment déterminé auquel apparaît une vitesse de variation de tension caractéristique est un point d'inflexion de l'augmentation de tension au cours d'un processus de charge.

5. Procédé selon l'une des revendications 1 à 4, caractérisé par le fait qu'on surveille la tension aux bornes et on n'opère un alignement de la valeur effective d'état de charge, déterminée par voie coulométrique, sur la valeur de référence préfixée, correspondant à chaque point d'alignement, que lorsque, au cours d'un cycle de charge-décharge, une tension de seuil préfixée est dépassé par en-dessus ou par en-dessous.

6. Procédé selon l'une des revendications 1 à 5, caractérisé par le fait qu'on mesure en outre la température de batterie ou de cellules et on en tient compte pour l'identification des points d'alignement et le calcul de valeur effective de l'état de charge.

7. Procédé selon l'une des revendications 1 à 6, caractérisé par le fait que l'on compense par le calcul les variations du comportement dans le temps de la tension de la batterie en fonction des variations du courant de charge ou de décharge.

8. Procédé selon l'une des revendications 1 à 7, caractérisé par le fait que l'on compense par le calcul des variations du comportement dans le temps de la tension de la batterie en fonction de la température des éléments ou de la batterie.

9. Procédé selon l'une de revendications 1 à 8, caractérisé par le fait que l'on relève et traite les valeurs de mesure selon une fréquence de cadence variable prefixée, et on augmente la fréquence de cadence au voisinage des points d'alignement pour augmenter la précision de mesure.

10. Procédé selon l'une des revendications 1 à 9, caractérisé par le fait que l'on détermine la vitesse de variation de la tension aux bornes par le calcul de quotients différentiels déduits de la tension et du temps et, à l'aide d'une mémorisation intermédiaire des quotients différentiels, on obtient des dérivés d'ordre plus élevé, pour l'identification des points d'alignement.

11. Appareil pour la mise en œuvre du procédé selon l'une des revendications 1 à 10, caractérisé par:

    – des dispositifs de mesure de la tension aux bornes $(U_U)$ de la batterie (1), du sens et de l'amplitude du courant de charge et de décharge et de la température de batterie $(U_T)$

    – une unité de calcul (11) commandée par programme qui est reliée aux dispositifs de mesure et commandée de telle sorte qu'elle surveille la vitesse de variation de la tension aux bornes $(U_U)$ pendant tout le cycle de charge et de décharge de la batterie (1) et détermine à un certain moment une valeur effective d'état de charge lorsque la vitesse de variation de tension subit une forte variation après une phase sensiblement constante

    – une mémoire (12, 13) qui est reliée à l'unité de calcul (11) pour mémoriser des valeurs de référence et les valeurs effectives, développées dans l'unité de calcul, des quantités d'énergie fournies ou consommées, la valeur effective de l'état de charge, déterminée à ce moment ou à un moment en retard défini sur celui-ci, étant alignée sur la valeur de référence préfixée, dans l'unité de recherche et

    – un circuit d'interface et d'excitation (14) pour coupler l'unité de calcul (11) avec des appareils périphériques d'entrée et de sortie (15, 16, 17, 4, 5).

12. Appareil selon la revendication 11, caractérisé par le fait que les dispositifs de mesure sont reliés à l'unité de calcul (11) par l'intermédiaire d'un multiplexeur (8), un convertisseur analogique-numérique (9) et un bus (10).

13. Appareil selon la revendication 12, caractérisé par le fait que la fréquence d'échantillonnage du convertisseur analogique-numérique (9) est commandable par l'unité de calcul (11).

14. Appareil selon une des revendications 11 à 13, caractérisé par le fait que le dispositif de mesure de courant comporte une résistance de précision (7) qui se trouve dans le circuit de courant de la batterie (1) et qui, sur son côté relié à la batterie, est maintenue à un potentiel préfixé.

15. Appareil selon une des revendications 11 à 14, caractérisé par le fait qu'il est prévu une mémoire de programme (12), pour commander l'unité de calcul (11), qui contient un programme pour corriger les valeurs effectives d'état de charge et les points d'alignement en fonction des variations de température et de courant.

16. Appareil selon l'une des revendications 11 à 15, caractérisé par le fait que le circuit d'interface et d'excitation (14) est muni d'organes de réglage ou commutateurs (4, 5) pour couper le circuit du courant de charge et décharge lors de dépassement par en-dessus ou par en-dessous des valeurs limites préfixées de la tension aux bornes $(U_U)$.

Fig. 1

Fig. 2

Fig. 3